(19) Europäisches Patentamt
European Patent Office
Office européen des brevets

(11) **EP 2 871 773 B1**

(12) **FASCICULE DE BREVET EUROPEEN**

(45) Date de publication et mention
de la délivrance du brevet:
**29.06.2016 Bulletin 2016/26**

(51) Int Cl.:
*H03H 9/02* *(2006.01)*    *H03H 9/46* *(2006.01)*
*H03H 9/52* *(2006.01)*

(21) Numéro de dépôt: **14191406.9**

(22) Date de dépôt: **03.11.2014**

(54) **Dispositif MEMS/NEMS comportant un réseau de résonateurs à actionnement électrostatique et à réponse fréquentielle ajustable, notamment pour filtre passe-bande**

Mikroelektronische/nanoelektronische Vorrichtung, die ein Resonatorennetz mit elektrostatischer Auslösung und anpassbarer Frequenzantwort umfasst, insbesondere für Bandpassfilter

MEMS/NEMS device comprising an array of electrostatic actuation resonators with adjustable frequency response, in particular for a bandpass filter

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.11.2013 FR 1360855**

(43) Date de publication de la demande:
**13.05.2015 Bulletin 2015/20**

(73) Titulaire: **COMMISSARIAT A L'ENERGIE ATOMIQUE ET AUX ENERGIES ALTERNATIVES**
**75015 Paris (FR)**

(72) Inventeurs:
• **Arcamone, Julien**
  **38000 Grenoble (FR)**
• **Arndt, Grégory**
  **38240 Meylan (FR)**

(74) Mandataire: **Esselin, Sophie et al**
**Marks & Clerk France**
**Conseils en Propriété Industrielle**
**Immeuble Visium**
**22 Avenue Aristide Briand**
**94117 Arcueil Cedex (FR)**

(56) Documents cités:
**EP-A1- 2 197 106    FR-A1- 2 929 775**
**FR-A1- 2 973 504**

• **SAGE E ET AL: "Frequency-addressed NEMS arrays for mass and gas sensing applications", 2013 TRANSDUCERS & EUROSENSORS XXVII: THE 17TH INTERNATIONAL CONFERENCE ON SOLID-STATE SENSORS, ACTUATORS AND MICROSYSTEMS (TRANSDUCERS & EUROSENSORS XXVII), IEEE, 16 juin 2013 (2013-06-16), pages 665-668, XP032499609, DOI: 10.1109/TRANSDUCERS.2013.6626854**

EP 2 871 773 B1

**Description**

Le domaine de l'invention est celui des composants radiofréquence (pour le filtrage en particulier), et notamment celui des capteurs à base de résonateurs (pour application capteur de variations de fréquence de résonance tels que des capteurs de masse ou de gaz en particulier).

De manière générale, les microsystèmes, dénommés MEMS et/ou NEMS pour Micro et/ou Nano ElectroMechanicalSystems, sont des composants fabriqués au moyen des procédés de la microélectronique, dont certaines dimensions peuvent aller de quelques dizaines de nanomètres à quelques centaines de micromètres.

De nombreuses recherches sont menées autour de ces composants car ils permettent la réalisation de fonctions (capteur ou actionneur) soit difficilement réalisables avec les composants « classiques » de la microélectronique, soit procurant comparativement des performances supérieures. Par exemple, des capteurs d'accélération ou de pression sont déjà commercialisés et utilisés dans de nombreuses applications (automobile, jeux vidéo, téléphonie mobile).

Les composants pour la radiofréquence (RF) représentent un autre domaine applicatif des MEMS. On peut d'emblée citer l'utilisation de résonateurs SAW ou BAW pour des applications de filtrage dans la chaine d'acquisition ou de réception d'un module de communications RF. De tels composants ont déjà été commercialisés de même que des résonateurs MEMS haute-fréquence implémentés en bases de temps de circuit électronique.

Un des objectifs de la communication RF est de concevoir des modules de communication qui peuvent être réglables en fréquence. En d'autres termes, la fréquence d'opération du module de communication peut être ajustée afin de s'adapter aux différents standards de communication.

Les résonateurs à actionnement électrostatique représentent une solution potentielle pour réaliser des filtres ajustables, qui sont les briques de base des modules de communication ajustables.

A cet effet, il a déjà été proposé des exemples de filtres réalisés à partir de réseaux de résonateurs, décrits dans la demande de brevet FR2929775. Dans cette demande de brevet, la dispersion de la fréquence de résonance due à la variabilité du procédé de fabrication est utilisée pour réaliser un filtre passe-bande dont la bande passante est donc déterminée par les variations dimensionnelles induites par la dispersion technologique, entre des résonateurs nominalement identiques. Ce type de configuration repose donc sur la dispersion technologique, ce qui est aléatoire et non contrôlable.

La demande de brevet EP 2 197 106 décrit quant à elle, un dispositif MEMS/NEMS comprenant des résonateurs reliés électriquement en série mais ces résonateurs sont adressés individuellement à un potentiel Vi. Il y a donc autant de tensions d'actionnement que de résonateurs. Un tel dispositif à n résonateurs requiert n+2 tensions de réglage [Ve,Vi (avec i allant de 1 à n), Vdc], ce qui peut être particulièrement pénalisant dans le cas d'un réseau comportant de nombreux résonateurs.

C'est pourquoi dans ce contexte, la présente invention a pour objet un dispositif MEMS/NEMS permettant de contrôler les dispersions de fréquence de résonance afin d'ajuster la réponse fréquentielle globale d'un dispositif utilisant un réseau de résonateurs et de conception simplifiée.

Plus précisément, la présente invention a pour objet un dispositif MEMS/NEMS à réponse fréquentielle ajustable comportant un ensemble de résonateurs à actionnement électrostatique, un circuit d'actionnement électrostatique desdits résonateurs, des moyens de détection électrique, et des moyens pour ajuster la réponse en fréquence de l'ensemble desdits résonateurs caractérisé en ce que :

- ledit dispositif comporte au moins un réseau de n résonateurs présentant une partie mobile, lesdits n résonateurs étant reliés électriquement en série entre un premier potentiel de polarisation $V_B$ et un deuxième potentiel de polarisation $V_{B2}$, chaque ième résonateur étant polarisé à un potentiel Vi compris entre ledit potentiel $V_B$ et ledit potentiel $V_{B2}$, suivant sa position dans la série ;
- ledit circuit d'actionnement électrostatique desdits résonateurs comportant pour chaque résonateur une électrode d'actionnement en regard de ladite partie mobile du résonateur, l'ensemble desdites électrodes d'actionnement étant reliées en parallèle à un potentiel de commande commun $V_{IN}$, la tension d'actionnement de chaque ième résonateur étant égale à $V_{IN}$ - Vi ;
- lesdits moyens de détection comprenant une sortie de détection commune auxdits n résonateurs reliée à un potentiel de sortie $V_{out}$ ;
- lesdits moyens pour ajuster la réponse en fréquence, faisant varier ledit potentiel de commande commun et/ou au moins l'un des premier et deuxième potentiels de polarisation.

Ainsi, le dispositif de la présente invention permet de n'utiliser que trois tensions de réglage ($V_B$, $V_{B2}$, $V_{IN}$), les potentiels Vi des résonateurs découlant des tensions $V_B$ et $V_{B2}$ ainsi que leur positionnement dans la série de résonateurs. L'invention permet donc un dispositif simplifié présentant beaucoup moins de paramètres de réglages que dans l'art antérieur constitué par la demande de brevet EP 2 197 106 et ne nécessitant pas de couplage mécanique ; une telle simplicité permet d'améliorer la fiabilité du système et sa mise en oeuvre, voire même d'améliorer sa densité d'intégration.

Le résonateur est dit être polarisé à un potentiel Vi, ledit potentiel Vi correspondant à une valeur moyenne de polarisation comprise entre Vi et Vi-1, correspondant aux valeurs des potentiels des noeuds de part et d'autre du ième résonateur.

Selon une variante de l'invention, les moyens de détection sont des moyens de détection capacitive, comprenant un ensemble d'électrodes de détection couplées aux n résonateurs, lesdites électrodes de détection étant reliées audit potentiel de sortie $V_{out.}$

Selon une variante de l'invention, les moyens de détection sont des moyens de détection piézorésistifs, de la résistivité de l'ensemble des n résonateurs reliés en série.

Selon une variante de l'invention, le second potentiel de polarisation $V_{B2}$ étant nul, le potentiel de sortie présente une valeur non nulle inférieure à celle du premier potentiel de polarisation, les résonateurs étant montés en série avec une résistance de valeur égale à n fois celle d'un unique résonateur.

Selon une variante de l'invention, les résonateurs sont des poutres encastrées-libres.

Selon une variante de l'invention, les résonateurs sont des poutres bi-encastrées.

Selon une variante de l'invention, les résonateurs sont des résonateurs plaque.

On entend par résonateur plaque un résonateur ayant une forme quelconque dans un plan principal : carré, rectangle anneau, disque ovale.

Selon une variante de l'invention, le dispositif comprend des paires d'électrodes d'actionnement et des paires d'électrodes de détection couplées à chaque résonateur plaque, pouvant être actionné en mode de Lamé. Le mode Lamé est préférentiel mais d'autres modes tels que par exemple le mode extensionnel, peuvent être utilisés.

Selon une variante de l'invention, les n résonateurs présentent une raideur et un entrefer avec l'électrode d'actionnement associée, définissant une tension continue d'actionnement pour chaque résonateur approximée à la valeur $V_{DC}(i) = V_{IN\ DC} - Vi$, (i étant l'indice du résonateur dans la chaîne) telle que la moyenne sur toutes les tensions d'actionnement $M[V_{DC}(i)]$, avec i variant de 1 à n, est sensiblement égale à la valeur $n \times \sigma[V_{DC}(i)]$, avec $\sigma[V_{DC}(i)]$, l'écart type desdites tensions.

Il est à noter que cette approximation peut être faite pour des nombres importants, sinon l'approximation suivante peut être prise en compte :

$$V_{DC}(i) = V_{IN\ DC} - V_{B2} - (2n - 2i+1)/(V_B - V_{B2})/2n \text{ avec } V_B \text{ et } V_{B2} \text{ les}$$

les premier et second potentiels.

Selon une variante de l'invention, les n résonateurs présentent des dimensions géométriques identiques ou quasi-identiques.

L'invention a aussi pour objet un filtre RF à réponse fréquentielle ajustable comprenant un dispositif MEMS/NEMS selon l'invention.

L'invention a encore pour objet un capteur de détection de variation de fréquence comprenant un dispositif MEMS/NEMS selon l'invention. Le capteur peut être notamment un capteur de masse ou bien encore un capteur de gaz.

L'invention sera mieux comprise et d'autres avantages apparaîtront à la lecture de la description qui va suivre donnée à titre non limitatif et grâce aux figures annexées parmi lesquelles :

- la figure 1 illustre un schéma de réseau de 3 résonateurs montés en parallèle selon l'art connu;
- la figure 2 illustre la réponse d'un réseau de 3 résonateurs MEMS disposés en parallèle et présentant une dispersion de fréquence naturelle de résonance de 3%;
- la figure 3 illustre la réponse d'un réseau de 10 résonateurs MEMS disposés en parallèle et présentant une dispersion de fréquence naturelle de résonance de 1% et celle d'un réseau de 100 résonateurs MEMS disposés en parallèle et présentant une dispersion de fréquence naturelle de résonance de 0,1%;
- la figure 4 illustre la réponse d'un réseau de 100 MEMS pour différentes dispersions en fréquence de résonance;
- la figure 5 illustre le schéma de principe d'un premier exemple de variante de l'invention dans laquelle les n résonateurs sont de type poutre bi-encastrée avec des moyens de détection piézorésistive ;
- la figure 6 illustre le schéma de principe d'un second exemple de variante de l'invention dans laquelle les n résonateurs sont de type poutre bi-encastrée avec des moyens de détection capacitive en mode 3 ports;
- la figure 7 illustre le schéma de principe d'un troisième exemple de variante de l'invention dans laquelle les n résonateurs sont de type poutre encastrée-libre avec des moyens de détection capacitive;
- la figure 8 illustre le schéma d'un résonateur plaque à actionnement électrostatique et détection capacitive utilisé dans un exemple de réalisation de la présente invention;
- la figure 9 illustre le schéma d'un réseau de 3 résonateurs plaque montés en série, tels que celui représenté en figure 8;

- la figure 10 illustre le gain d'un réseau de 10000 résonateurs plaque pour différentes différences de potentiel $\Delta V_B$ appliqué sur la série des 10000 résonateurs plaque.

De manière générale, le dispositif de la présente invention comprend au moins un réseau linéique de résonateurs dont le mode d'actionnement est électrostatique. Le mode de détection peut quant à lui varier, il peut notamment être de type capacitif ou de type piézorésistif. Le dispositif de la présente invention va être décrit ci-après dans le cadre d'un seul réseau, mais pourrait également comprendre tout aussi bien un ensemble de réseaux linéiques.

Quelques notions générales concernant les résonateurs de type MEMS sont rappelées ci-après.

Un résonateur MEMS est un dispositif électromécanique constitué d'une partie mobile (structure mécanique vibrante) et peut comprendre deux transducteurs électromécaniques : un premier transducteur d'actionnement et un second transducteur de détection. Le premier transducteur, pour actionner la structure, génère une force sur la partie mobile la mettant ainsi en mouvement. Le second transducteur permet la détection électrique du mouvement mécanique de ladite partie mobile. Les transductions d'actionnement les plus courantes sont de type électrostatique, magnétique, thermomécanique et piézoélectrique. De manière générale, les techniques de détection les plus courantes sont les détections capacitive, piézorésistive, magnétomotrice et piézoélectrique.

Le terme de résonateur est utilisé car la fonction de transfert définie entre la force exercée sur la partie mécanique mobile et le déplacement de celle-ci, calculée à partir de l'équation de mouvement du système, a un comportement fréquentiel défini mathématiquement par une fonction lorentzienne. La structure mécanique est donc principalement définie par sa fréquence naturelle de résonance $f_0$ et par son facteur de qualité Q.

Une propriété intéressante de l'actionnement électrostatique est que la différence de potentiel continu $V_{DC}$ entre le résonateur et l'électrode d'actionnement modifie la fréquence de résonance $f_R$ du MEMS et a tendance à la diminuer selon une loi du type $f_R = f_0 (1 - \alpha V_{DC}^2)$, $\alpha$ étant un coefficient positif. Cet effet de diminution de la raideur du résonateur, qui a pour effet de diminuer la fréquence de résonance, est connu dans la littérature sous la dénomination en langue anglaise « *spring-softening effect* ». Il est à noter qu'il a été montré dans la littérature des phénomènes similaires pour d'autres types d'actionnement mais la dépendance entre la tension $V_{DC}$ et la fréquence $f_R$ est plus faible.

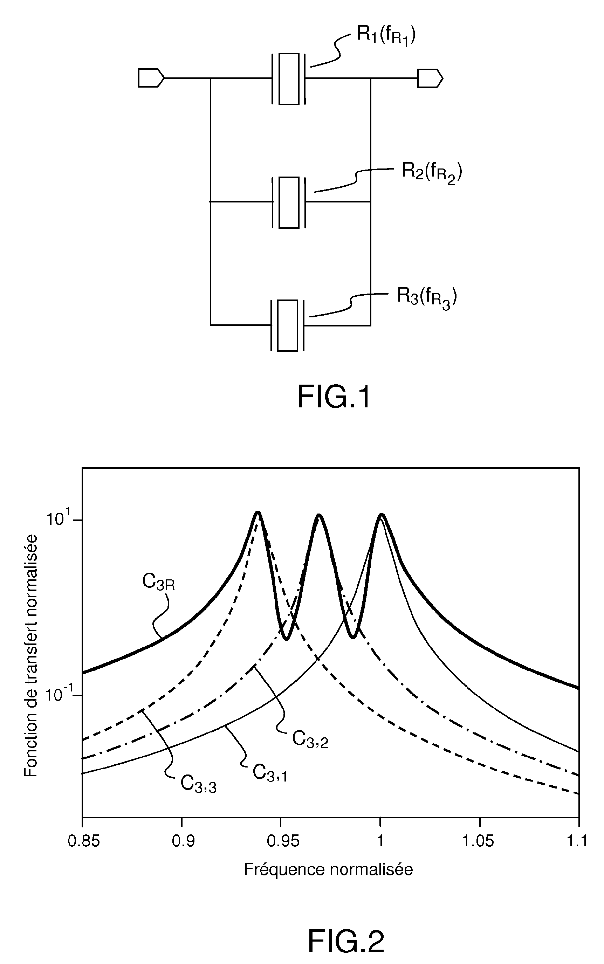

Lorsque l'on réalise un réseau de résonateurs disposés en parallèle (électrodes d'actionnement toutes interconnectées, de même pour les électrodes de détection, ces interconnections étant réalisées sur ou hors puce) et ayant chacun une fréquence de résonance différente, comme présenté sur la figure 1 dans le cas de trois résonateurs R1($f_{R1}$), R2 ($f_{R2}$) et R3($f_{R3}$) disposés en parallèle, le même signal d'actionnement est appliqué simultanément sur tous les résonateurs du réseau.

Les signaux résultants de chaque MEMS sont ensuite sommés, soit par le réseau lui-même (toutes les électrodes de détection des résonateurs sont interconnectées par une piste commune reliée à un unique plot de sortie), soit à l'extérieur de la puce (interconnexion des fils connectés à chaque électrode de détection), cette solution étant moins pratique.

Dans le cas présent d'un réseau de 3 résonateurs montés en parallèle, la courbe $C_{3R}$ de la figure 2 représente la fonction de transfert du réseau de 3 résonateurs MEMS avec une dispersion de fréquence naturelle de résonance de 3% (dans cet exemple, le facteur de qualité de chaque MEMS est 100). Les fréquences de résonance sont normalisées par rapport au 1er MEMS, ainsi la fréquence de résonance du 1er MEMS est égale à 1, celle du 2ème est égale à 0.97 et celle du 3ème est égale à 0.94. Les fonctions de transfert individuelles de chaque MEMS sont aussi représentées par les courbes $C_{3,1}$, $C_{3,2}$ et $C_{3,3}$. On observe que la fonction de transfert du réseau comporte des vagues autour des fréquences de résonance de chaque MEMS.

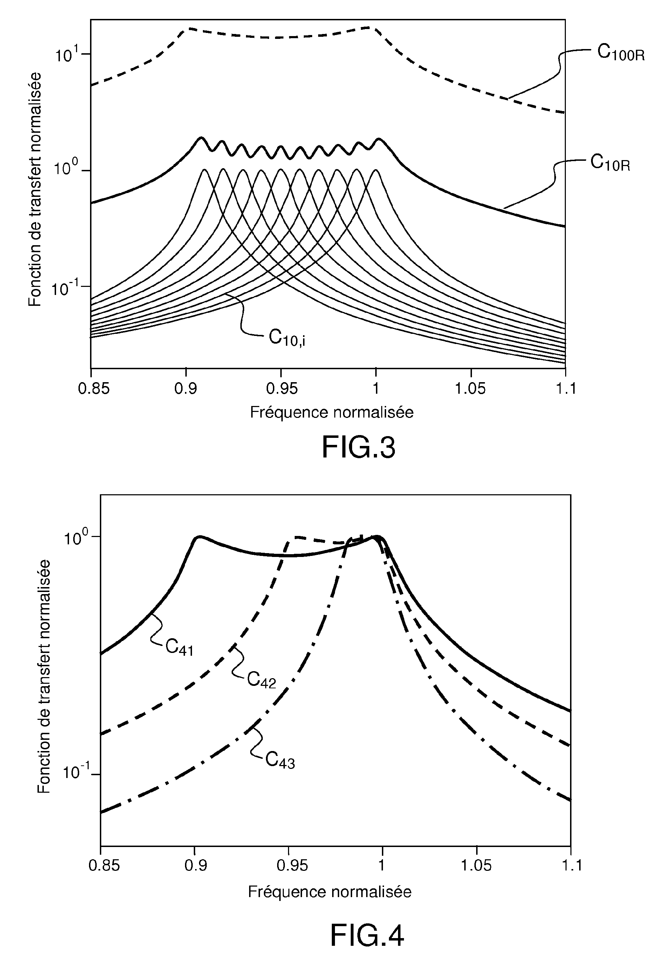

Le cas d'un réseau de 10 MEMS avec une dispersion de fréquence naturelle de résonance de 1% est également illustré en figure 3 et est plus significatif. Les vagues autour des fréquences naturelles de résonance de chaque MEMS sont réduites et la fonction de transfert du réseau est proche de celle d'un filtre passe-bande. La fonction de transfert du réseau de 10 MEMS est illustrée par la courbe $C_{10R}$, les fonctions de transfert individuelles sont illustrées par les courbes $C_{10,i}$.

La fonction de transfert d'un réseau de 100 MEMS (avec une dispersion de fréquence naturelle de résonance de 0.1%) a été ajoutée en pointillés et est illustrée par la courbe $C_{100R}$. On peut observer une courbe sans vague avec un comportement très proche de celui d'un filtre passe bande.

Ainsi, les figures 2 et 3 mettent en évidence qu'il est possible de réaliser un filtre passe-bande au moyen d'un réseau d'un grand nombre de résonateurs. A noter que dans ces exemples, la dispersion des fréquences naturelles de résonance $f_0$ définit la largeur de la bande passante du filtre.

Si par ailleurs les fréquences de résonance de chaque MEMS peuvent être ajustées d'une manière ou d'une autre, il est alors possible de contrôler la bande passante du filtre. La figure 4 illustre ce dernier propos : les fonctions de transfert de 3 réseaux de MEMS y sont représentées pour 3 valeurs de dispersion en fréquence (courbe $C_{41}$ : $\Delta f_R$= 0,1%, courbe $C_{42}$ : $\Delta f_R$=0,05% et courbe $C_{43}$ : $\Delta f_R$=0,02%).

Le but recherché dans la présente invention est de contrôler les dispersions de fréquence de résonance afin d'ajuster la réponse fréquentielle globale du réseau. Plutôt que d'agir principalement sur les fréquences naturelles de

résonance $f_0$ des résonateurs (qui dépendent des matériaux et des dimensions géométriques), il est proposé d'ajuster les fréquences de résonance $f_R$ via la différence de potentiel continu $V_{DC}$ imposée entre le résonateur et l'électrode d'actionnement, par le biais du « *spring-softening effect* ».

L'invention porte ainsi sur un dispositif comprenant un réseau de résonateurs MEMS avec actionnement électrostatique, à réponse fréquentielle ajustable, dont une des applications principalement visées est la fonction filtre passe-bande avec fréquence centrale et bande-passante ajustables.

Plus précisément, les caractéristiques principales de fonctionnement du dispositif de l'invention avec son réseau de n résonateurs et des électrodes d'actionnement desdits résonateurs sont les suivantes :

- en appliquant sur une entrée commune, une tension d'actionnement $V_{IN-AC}$ (partie AC) + $V_{IN-DC}$ (partie DC), l'actionnement étant réalisé par force électrostatique, tous les résonateurs sont actionnés simultanément avec le même signal;
- en délivrant une sortie unique, porteuse du signal de détection électromécanique de l'ensemble des résonateurs du réseau, via le fait que :

  o pour des résonateurs à détection capacitive, en mode 3 ports toutes les électrodes de détection sont interconnectées, ou en mode 2 ports tous les résonateurs sont interconnectés ;
  o pour des résonateurs à détection piézorésistive, tous les résonateurs sont interconnectés.

Quel que soit le mode de détection, les résonateurs sont électriquement disposés en série, de telle sorte que l'extrémité électrique de cette chaîne est portée à un certain potentiel référencé $V_B$, l'autre extrémité étant portée à un potentiel référencé $V_{B2}$ (la masse dans la plupart des figures suivantes, mais toute autre valeur étant possible).

Si l'on numérote avec l'indice i allant de 1 à n, chaque résonateur depuis l'extrémité portée à $V_B$ jusqu'à l'autre, et $V_i$ le potentiel du noeud entre le résonateur $R_{i-1}$ et le résonateur $R_i$, la valeur de $V_i$ suit une loi du type :

$$V_i = (n-i)/n \; (V_B - V_{B2})$$

Par conséquent, la différence de potentiel continu $V_{DC}$ entre le résonateur et l'électrode d'actionnement diffère en tout point de la chaîne dont une extrémité est à $V_B$ et l'autre à $V_{B2}$.

Ce qui signifie par extension que tous les résonateurs sont actionnés par une tension continue $V_{DC}$ d'actionnement qui leur est propre, que l'on note $V_{DC}(i)$ et que l'on peut approximer comme explicité précédemment par l'équation :

$$V_{DC} \, (i) = V_{IN \, DC} - V_i \, ,$$

Si les résonateurs du réseau sont tous identiques en termes de dimensions, de distance d'entrefer g et de dimensions d'électrode, alors ils ont tous une fréquence de résonance différente conformément à l'effet « *spring-softening* » (bien qu'ils aient une fréquence naturelle $f_0$ identique), qui se traduit mathématiquement par une loi du type :

$$f_{Ri} = f_0 \, [1 - C_0 \, V_{DC}^{\;2} \, (i) \, /(k \, g^{\;2})]$$

k étant la raideur (en N/m) des résonateurs et $C_0$ la capacité statique entre le résonateur et son électrode d'actionnement. Il est à noter qu'aucun couplage mécanique n'est requis entre les résonateurs.

Typiquement, la tension $V_{B2}$ peut être égale à 0.

Ainsi, en jouant sur le potentiel $V_{IN\_DC}$ et sur le potentiel $V_B$, on peut influer sur le potentiel $V_{DC}(i)$, et donc faire varier les fréquences de résonance $f_{Ri}$.

C'est par ce biais que l'on peut influer sur la réponse fréquentielle du réseau qui peut alors prendre plusieurs formes :

o une réponse en forme de pic unique (les fréquences $f_{Ri}$ sont très proches les unes des autres, les pics individuels se sommant),
o l'opposé étant une réponse en forme de peigne, chaque pic étant bien différencié et avec une amplitude potentiellement différente, et
o la réponse intermédiaire, la plus adaptée à la réalisation de la fonction filtre passe-bande, du type de celle représentée dans les figures 3 et 4.

L'homme de l'art peut, par simulation analytique (basée sur la prise en compte du comportement électromécanique des résonateurs et du schéma électrique du réseau) ou par conception assistée par ordinateur (CAO), modéliser efficacement ce système et choisir les points de fonctionnement $V_{IN\,DC}$ et $V_B$ nécessaires à l'obtention du régime de son choix parmi les trois précédemment décrits.

En posant $M[V_{DC}(i)] = (\sum_{i=1}^{n} V_{DC}(i))/n,$ la moyenne sur i des $V_{DC}(i)$

et

$\sigma[V_{DC}(i)]$, l'écart-type des $V_{DC}(i)$.

Les lois de comportement de la réponse fréquentielle du réseau ainsi constitué, qui dépendent tout particulièrement du type de résonateur (de sa raideur k entre autres) et de son entrefer, peuvent être généralisées de la manière suivante :

- pour $M[V_{DC}(i)] \gg \sigma[V_{DC}(i)]$, la dispersion des fréquences de résonance devient négligeable et on retrouve une réponse en forme de pic unique ;
- pour $M[V_{DC}(i)] \ll \sigma[V_{DC}(i)]$, les fréquences de résonance varient de manière importante et les pics sont tous séparés;
- pour $M[V_{DC}(i)] \approx n \times \sigma[V_{DC}(i)]$, les fréquences de résonance varient certes de manière notable mais en ajustant $V_{IN\,DC}$ en fonction de $V_B$, il est possible d'obtenir une réponse de type filtre passe-bande.

Ce dernier cas de figure est celui auquel s'est plus particulièrement intéressé le Demandeur.

Contrairement à des solutions de l'art connu et notamment celle décrite dans la demande de brevet FR 2929775, dans laquelle la dispersion technologique est utilisée, ce qui est aléatoire et non contrôlable, pour obtenir des fréquences différentes entre chaque résonateur, la présente invention permet d'ajuster la fréquence centrale et la bande-passante du filtre obtenu en configurant le système de manière à obtenir une réponse du type filtre passe-bande.

Ce concept est applicable potentiellement à tout type de résonateur mécanique.

Les résonateurs peuvent tous avoir des dimensions différentes et une distance d'entrefer différente mais dans une réalisation préférentielle il est plus simple, notamment en terme de modélisation, qu'ils soient tous identiques.

Comme mentionné précédemment, la présente invention a pour application principale l'obtention d'un filtre passe-bande de fréquence centrale et bande-passante ajustables. Mais la présente invention peut également faciliter la mise en oeuvre de la méthode de mesure décrite dans la demande de brevet FR2973504 ou dans l'article de E. Sage, O. Martin, C. Dupré, T. Ernst, G. Billiot, L. Duraffourg, E. Colinet, and S. Hentz, "FREQUENCY-ADDRESSED NEMS ARRAYS FOR MASS AND GAS SENSING APPLICATIONS", in the proceedings of the IEEE Transducers conference 2013, qui portent sur une méthode de mesure d'un réseau de résonateurs pour réaliser des capteurs de masse ou de gaz. L'implémentation de cette méthode requiert que les fréquences de résonance de tous les résonateurs du réseau soient différentes, ce qui est obtenu dans la publication *"FREQUENCY-ADDRESSED NEMS ARRAYS FOR MASS AND GAS SENSING APPLICATIONS",* par le fait que les résonateurs ont tous des dimensions géométriques différentes (concrètement une longueur différente).

Grâce à la solution présentée dans la présente invention ici proposée, il est possible de faire en sorte que les fréquences de résonance des résonateurs du réseau soient toutes différentes, tout en ayant les mêmes dimensions, permettant d'ajuster les écarts de fréquence sur demande.

Cette propriété peut également avantageusement permettre de réaliser des capteurs de masse ou de gaz.

Premier exemple de dispositif selon l'invention

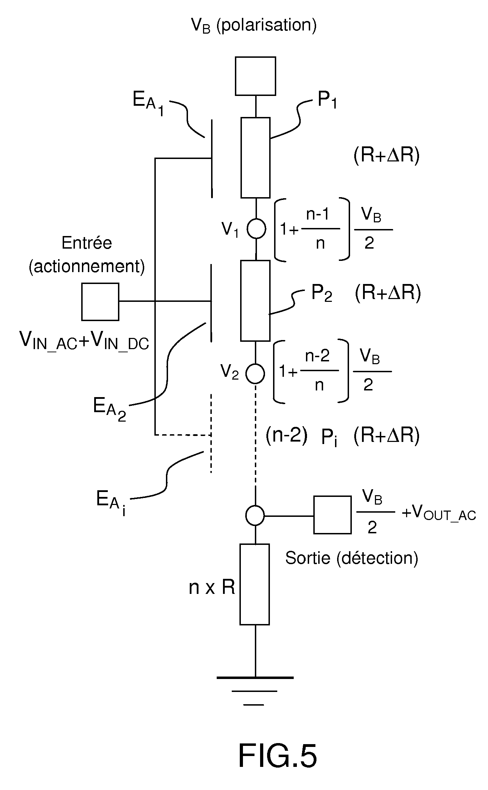

A titre d'exemple, la figure 5 illustre un mode de réalisation de l'invention avec $V_{B2} = 0$ et avec un réseau de n résonateurs Pi intégrant des jauges piézorésistives ou étant couplés à des jauges piézorésistives (non représentées), connectés électriquement en série entre le potentiel $V_B$ et la masse. L'ensemble de ces résonateurs peut être avantageusement monté en série avec une résistance unique de polarisation ou un ensemble de résistance(s), dont la valeur totale est n x R, permettant de réaliser la détection piézorésistive par mesure des variations de résistance de l'ensemble du réseau. Le potentiel de sortie de détection est alors :

$$V_B / 2 + V_{OUT\_AC}.\ \text{Le choix de la valeur n x R de la résistance de polarisation}$$

Le choix de la valeur n x R de la résistance de polarisation permet d'optimiser le gain en tension du réseau de résonateurs. Cette configuration s'apparente à la configuration classique d'un demi-pont de Wheastone.

Selon cet exemple, n résonateurs sont actionnés par des électrodes de commande $E_{Ai}$ reliées à un potentiel commun d'entrée $V_{IN-AC} + V_{IN\_DC}$.

Les résonateurs selon cet exemple peuvent typiquement être du type de ceux décrits dans la demande de brevet FR 2 917 731.

<u>Second exemple de dispositif selon l'invention.</u>

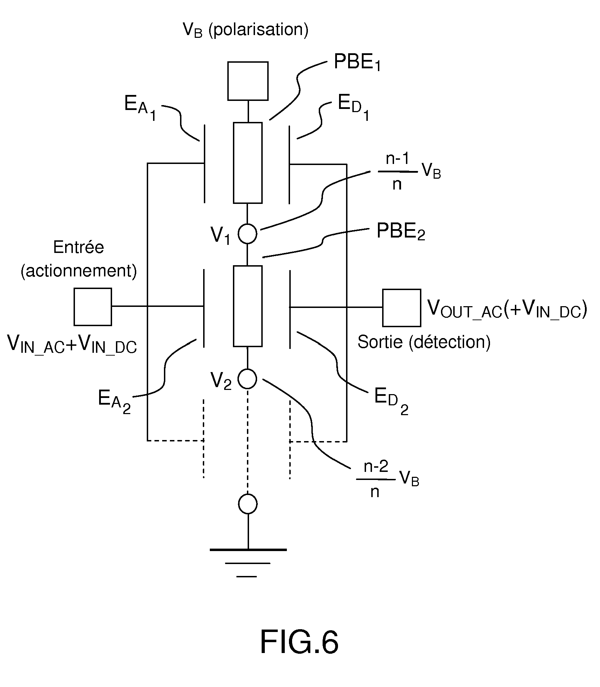

La figure 6 illustre un mode de réalisation de l'invention avec un réseau de poutres bi-encastrées à détection capacitive en mode 3 ports : une électrode d'actionnement, une de polarisation, une autre de détection. Sur cette dernière, il est préférable d'ajouter la tension $V_{IN\_DC}$ (la même imposée sur l'électrode d'entrée) afin d'égaliser les tensions DC exercées par les deux électrodes sur la poutre.

Plus précisément, selon cette variante le dispositif comprend un ensemble d'électrodes d'actionnement $E_{Ai}$, un ensemble de poutres bi-encastrées PBEi et un ensemble d'électrodes de détection $E_{Di}$.

Les poutres bi-encastrées sont interconnectées entre elles en série.

<u>Troisième exemple de dispositif selon l'invention.</u>

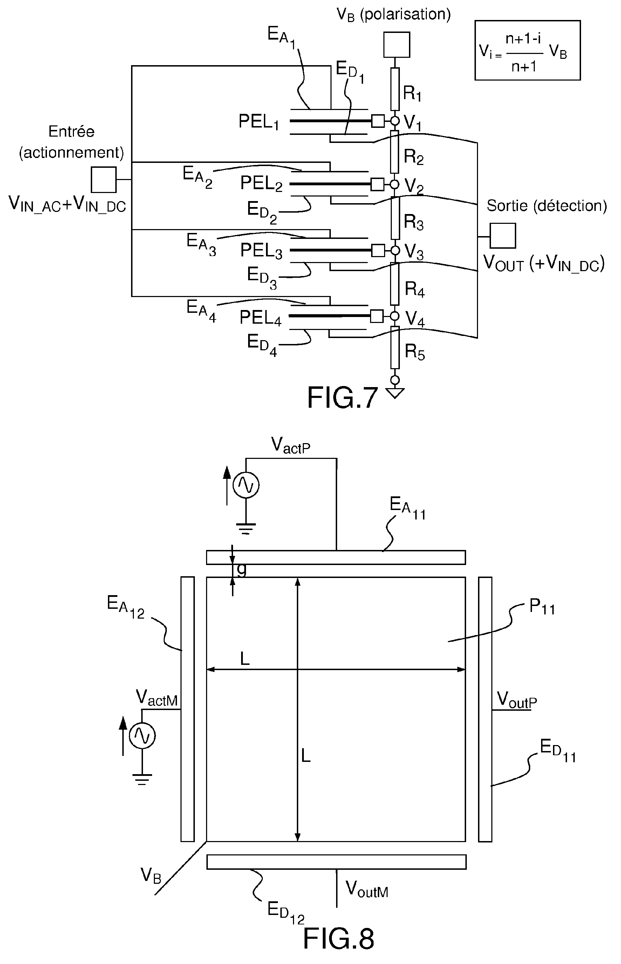

Selon cet exemple illustré en figure 7, les poutres sont des poutres encastrées uniquement au niveau de l'une de leurs extrémités, et non plus encastrées au niveau de leurs deux extrémités comme dans l'exemple illustré en figure 6, dénommées poutre encastrée-libre. La figure 7 schématise un exemple avec 4 poutres PEL1, PEL2, PEL3 et PEL4, couplées à 4 électrodes d'actionnement $E_{A1}$, $E_{A2}$, $E_{A3}$ et $E_{A4}$, sont également représentés les éléments : R1, R2, R3, R4 et R5 (correspondant à des résistances présentes entre les différents noeuds de potentiels Vi), ainsi que les potentiels le long de la série desdites poutres encastrée-libre montées en série. En sortie, 4 électrodes dédiées à la détection $E_{D1}$, $E_{D2}$, $E_{D3}$ et $E_{D4}$ sont reliées à un potentiel commun de sortie, dont la partie AC est $V_{OUT}$ (le signal de détection), la partie DC étant avantageusement fixée à $V_{IN\ DC}$ (afin d'égaliser les tensions DC exercées par les deux types d'électrodes sur la poutre).

<u>Exemple de réalisation de l'invention avec un réseau de résonateurs de type plaque à détection capacitive</u>

Le dispositif comprend des résonateurs plaque à détection capacitive et actionnés électrostatiquement en mode de Lamé (les structures étant mécaniquement ancrées aux quatre coins). Ces résonateurs sont intéressants car ils permettent d'atteindre facilement la gamme de la centaine de MHz en terme de fréquence de résonance.

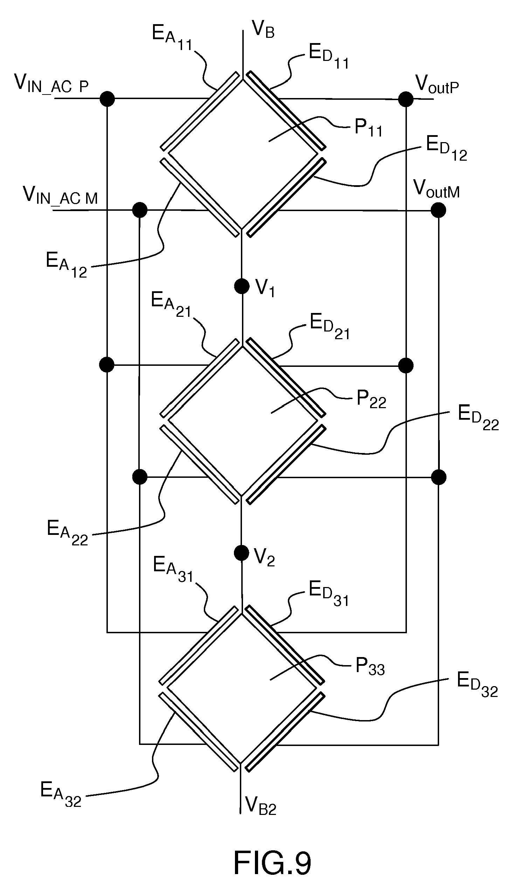

La figure 8 illustre un résonateur plaque (carrée) P11, ayant les dimensions suivantes: côté de longueur L et épaisseur h. Il est mis en mouvement à l'aide de deux électrodes à actionnement électrostatique sur lesquelles des tensions ac $V_{IN-AC\ P}(t)$ et $V_{IN\_AC\ M}(t) = - V_{IN-AC\ P}(t)$ sont appliquées sur chacune des électrodes $E_{A11}$ et $E_{A12}$ comme indiqué sur la figure 8, ou comme sur la figure 9 ($E_{A11}$, $E_{A21}$, $E_{A31}$ et $E_{A12}$, $E_{A22}$, $E_{A32}$) qui illustre un dispositif de l'invention dans lequel trois plaques P11, P22 et P33 sont connectées électriquement en série.

On a: $\Delta V_{IN\_AC}(t) = V_{IN\_AC\ P}(t) - V_{IN\_AC\ M}(t)$ et $V_{DC}$ la tension continue d'actionnement de la plaque (dans l'exemple présent, en reprenant les mêmes notations que dans les exemples précédents, $V_{DC} = -V_B$).

Le déplacement de cette plaque est ensuite mesuré grâce à deux autres électrodes à l'aide d'une transduction capacitive. Les tensions mesurées sur les électrodes de détection sont notées $V_{OUT\ P}(t)$ et $V_{OUT\ M}(t)$.

On a $\Delta V_{OUT}(t) = V_{OUT\ P}(t) - V_{OUTM}(t)$.

Respectivement ces paires d'électrodes de détection sont référencées en figure 8 : $E_{D11}$ et $E_{D12}$, et en figure 9 : $E_{D11}$ et $E_{D12}$, $E_{D21}$ et $E_{D22}$ et $E_{D31}$ et $E_{D32}$.

En se basant par exemple sur la publication des auteurs J. Arcamone, E. Colinet, A. Niel, E. Ollier, « Efficient capacitive transduction of high-frequency micromechanicalresonators by intrinsic cancellation of parasitic feedthrough capacitances », APPLIED PHYSICS LETTERS 97, 043505 (2010), on peut démontrer que la fonction de transfert de ce résonateur est:

$$\Delta \ddot{v}_{OUT} + \frac{2\pi f_0}{2Q} \Delta \dot{v}_{OUT} + (2\pi f_0)^2 \left( 1 - \frac{V_B^{\ 2}}{V_{softening}^{\ 2}} \right) \Delta v_{OUT} = 2 \frac{\varepsilon_0 hL}{g^2} V_B \Delta v_{INAC}$$

Avec :

$\Delta \ddot{v}_{OUT}$ : la dérivée seconde en fonction du temps

$\Delta \dot{v}_{OUT}$ : la dérivée première en fonction du temps

$\varepsilon_0$ : la permittivité diélectrique du vide.

Le terme $V_{softening}$ est égal à $\sqrt{\dfrac{k_{EFF}\,g^3}{2\varepsilon_0 hL}}$ où $k_{EFF}$ est la raideur effective de la plaque.

Dans le présent exemple, la tension de d'actionnement $V_{IN\_DC}$ est portée à 0, la différence de potentiel continu ($V_{DC}$) entre le résonateur et l'électrode d'actionnement est donc $V_{DC} = -V_B$.

Le terme $\dfrac{V_B{}^2}{V_{softening}{}^2}$ traduit le « *spring-softening effect* » décrit précédemment dans la présente demande.

Il est responsable de la variation de la fréquence de résonance avec la tension effective de polarisation continue $V_{DC}$. C'est aussi le phénomène qui est utilisé dans la présente invention afin de modifier la bande-passante du filtre passe-bande réalisé à l'aide de ce réseau de MEMS.

Dans le cas d'un réseau de n=10000 résonateurs plaque, le tableau 1 ci-après répertorie les différents paramètres géométriques et électriques:

| Epaisseur de plaque | h=3$\mu$m | Tension DC de polarisation | $V_B$=15 V |
|---|---|---|---|
| Longueur de plaque | L=41.25$\mu$m | Résistance à la sortie du réseau | $R_{load}$=50 $\Omega$ |
| Entrefer plaque / électrodes | g=80 nm | Capacité à la sortie du réseau | $C_{load}$=100 pF |
| Facteur de qualité | Q=10000 | | |

La tension sur chaque noeud entre deux résonateurs distincts est :

$$V_i = V_{B2} + \frac{n-i}{n}\Delta V_B \quad \text{avec} \quad \Delta V_B = V_B - V_{B2}$$

On peut approximer la tension effective d'actionnement vue par un résonateur d'indice i par :

$$V_{DC}(i) = V_{IN\,DC} - V_{B2} - \frac{2n - 2i + 1}{2n}\Delta V_B$$

Le gain en tension G du réseau peut alors être exprimé de la manière suivante :

$$G(f) = \frac{1}{\underbrace{{}^1/_{R_{load}} + j2\pi f(C_{load} + n\varepsilon_0 hL/g)}_{\text{Charge vue par le réseau}}} \underbrace{\left| \sum_{i=1}^{n} \frac{1}{2\pi f_{Ri} m} \frac{\left[\varepsilon_0 hLV_i\big/g^2\right]^2}{\underbrace{1 + {}^{jf}/_{Qf_{Ri}} - \left({}^{jf}/_{Qf_{Ri}}\right)^2}_{\text{Fonction lorentzienne}}} \right|^2}_{\text{Courant généré par le réseau}}$$

où m est la masse de la plaque, $f_{Ri}$ la fréquence de résonance du résonateur d'indice i.

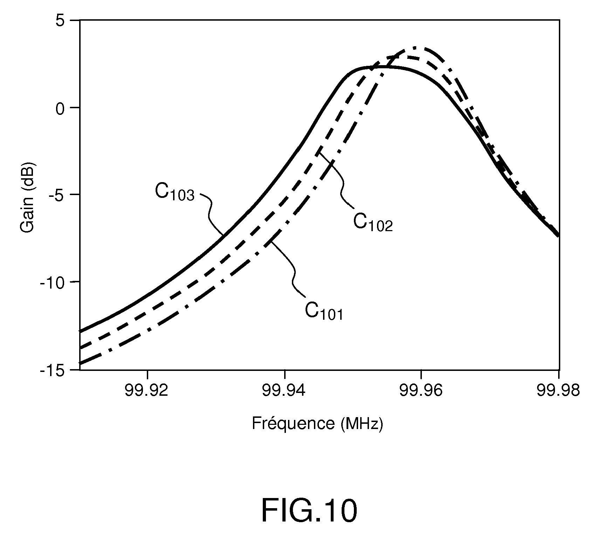

La figure 10 représente le gain du réseau avec 10000 résonateurs plaque pour différentes tensions de polarisation, la courbe $C_{101}$ est relative à un $\Delta V_B$ = 3V, la courbe $C_{102}$ est relative à un $\Delta V_B$ = 4V, la courbe $C_{103}$ est relative à un $\Delta V_B$ = 5V.

Cette figure illustre le fait que le réseau se comporte comme un filtre passe-bande de fréquence centrale et de bande-passante ajustables par des moyens simples et contrôlés.

**Revendications**

1. Dispositif MEMS/NEMS à réponse fréquentielle ajustable comportant un ensemble de résonateurs à actionnement électrostatique, un circuit d'actionnement électrostatique desdits résonateurs, des moyens de détection électrique, et des moyens pour ajuster la réponse en fréquence de l'ensemble desdits résonateurs,

   - ledit dispositif comportant au moins un réseau de n résonateurs présentant une partie mobile, lesdits n résonateurs étant reliés électriquement en série entre un premier potentiel de polarisation $V_B$ et un deuxième potentiel de polarisation $V_{B2}$, chaque ième résonateur étant polarisé à un potentiel Vi compris entre ledit potentiel $V_B$ et ledit potentiel $V_{B2}$, suivant sa position dans la série ;
   - ledit circuit d'actionnement électrostatique desdits résonateurs comportant pour chaque résonateur une électrode d'actionnement en regard de ladite partie mobile du résonateur, l'ensemble desdites électrodes d'actionnement étant reliées en parallèle à un potentiel de commande commun $V_{IN}$, la tension d'actionnement de chaque ième résonateur étant égale à $V_{IN}$ - Vi ;
   - lesdits moyens de détection comprenant une sortie de détection commune auxdits n résonateurs reliée à un potentiel de sortie $V_{out}$ ;
   - lesdits moyens pour ajuster la réponse en fréquence, faisant varier ledit potentiel de commande commun et/ou au moins l'un des premier et deuxième potentiels de polarisation.

2. Dispositif MEMS/NEMS à réponse fréquentielle ajustable comportant des résonateurs à actionnement électrostatique selon la revendication 1, **caractérisé en ce que** les moyens de détection sont des moyens de détection capacitive, comprenant un ensemble d'électrodes de détection couplées aux n résonateurs, lesdites électrodes de détection étant reliées audit potentiel de sortie $V_{out}$.

3. Dispositif MEMS/NEMS à réponse fréquentielle ajustable comportant des résonateurs à actionnement électrostatique selon la revendication 1, **caractérisé en ce que** les moyens de détection sont des moyens de détection piézorésistifs, de la résistivité de l'ensemble des n résonateurs reliés en série.

4. Dispositif MEMS/NEMS à réponse fréquentielle ajustable comportant des résonateurs à actionnement électrostatique selon l'une des revendications 1 ou 2, **caractérisé en ce que** les résonateurs sont des poutres encastrées-libres.

5. Dispositif MEMS/NEMS à réponse fréquentielle ajustable comportant des résonateurs à actionnement électrostatique selon l'une des revendications 1 ou 2, **caractérisé en ce que** les résonateurs sont des poutres bi-encastrées.

6. Dispositif MEMS/NEMS à réponse fréquentielle ajustable comportant des résonateurs à actionnement électrostatique selon l'une des revendications 1 à 4, **caractérisé en ce que** les résonateurs sont des résonateurs plaque,

7. Dispositif MEMS/NEMS à réponse fréquentielle ajustable comportant des résonateurs à actionnement électrostatique selon la revendication 6, **caractérisé en ce qu'**il comprend des paires d'électrodes d'actionnement et des paires d'électrodes de détection couplées à chaque résonateur plaque, pouvant être actionné en mode de Lamé.

8. Dispositif MEMS/NEMS à réponse fréquentielle ajustable comportant des résonateurs à actionnement électrostatique selon l'une des revendications 1 à 7, **caractérisé en ce que** les n résonateurs présentent une raideur et un entrefer avec l'électrode d'actionnement associée, définissant une tension continue d'actionnement pour chaque résonateur approximée à la valeur $V_{DC}$ (i) = $V_{IN\,DC}$ - Vi, telle que la moyenne sur toutes les tensions d'actionnement M [$V_{DC}$ (i)], avec i variant de 1 à n, est sensiblement égale à la valeur n x σ [$V_{DC}$ (i)], avec σ [$V_{DC}$(i)], l'écart type desdites tensions.

9. Dispositif MEMS/NEMS à réponse fréquentielle ajustable selon l'une des revendications 1 à 8, **caractérisé en ce que** les n résonateurs présentent des dimensions géométriques identiques ou quasi-identiques.

10. Filtre RF à réponse fréquentielle ajustable comprenant un dispositif MEMS/NEMS selon l'une des revendications 1 à 9.

11. Capteur de détection de variation de fréquence comprenant un dispositif MEMS/NEMS selon l'une des revendications 1 à 9.

**12.** Capteur de détection de masse comprenant un dispositif MEMS/NEMS selon l'une des revendications 1 à 9.

**13.** Capteur de détection de gaz comprenant un dispositif MEMS/NEMS selon l'une des revendications 1 à 9.

**Patentansprüche**

**1.** MEMS/NEMS-Vorrichtung mit justierbarem Frequenzgang, umfassend einen Satz von Resonatoren mit elektrostatischer Betätigung, eine Schaltung zum elektrostatischen Betätigen der Resonatoren, elektrische Erkennungsmittel und Mittel zum Justieren des Frequenzgangs des Satzes von Resonatoren,

- wobei die Vorrichtung wenigstens eine Anordnung von n Resonatoren mit einem beweglichen Teil umfasst, wobei die n Resonatoren elektrisch in Serie zwischen einem ersten Bias-Potential $V_B$ und einem zweiten Bias-Potential $V_{B2}$ geschaltet sind, wobei jeder i-te Resonator auf ein Potential Vi zwischen dem Potential $V_B$ und dem Potential $V_{B2}$ je nach seiner Position in der Serie vorgespannt ist;
- wobei die Schaltung zum elektrostatischen Betätigen der Resonatoren für jeden Resonator eine dem beweglichen Teil des Resonators zugewandte Betätigungselektrode umfasst, wobei der Satz von Betätigungselektroden parallel zu einem gemeinsamen Steuerpotential $V_{IN}$ geschaltet ist, wobei die Betätigungsspannung jedes i-ten Resonators gleich $V_{IN}$ - Vi ist;
- wobei die Erkennungsmittel einen Erkennungsausgang haben, der den n Resonatoren gemeinsam ist, die mit einem Ausgangspotential $V_{out}$ verbunden sind;
- wobei die Mittel zum Justieren des Frequenzgangs das gemeinsame Steuerpotential und/oder das erste und/oder zweite Bias-Potential variiert.

**2.** MEMS/NEMS-Vorrichtung mit justierbarem Frequenzgang, umfassend Resonatoren mit elektrostatischer Betätigung nach Anspruch 1, **dadurch gekennzeichnet, dass** die Erkennungsmittel kapazitive Erkennungsmittel sind, die einen Satz von Erkennungselektroden umfassen, die mit den n Resonatoren gekoppelt sind, wobei die Erkennungselektroden mit dem Ausgangspotential $V_{out}$ verbunden sind.

**3.** MEMS/NEMS-Vorrichtung mit justierbarem Frequenzgang, umfassend Resonatoren mit elektrostatischer Betätigung nach Anspruch 1, **dadurch gekennzeichnet, dass** die Erkennungsmittel piezoresistive Mittel zum Erkennen des Widerstands des Satzes von in Serie geschalteten n Resonatoren sind.

**4.** MEMS/NEMS-Vorrichtung mit justierbarem Frequenzgang, umfassend Resonatoren mit elektrostatischer Betätigung nach einem der Ansprüche 1 oder 2, **dadurch gekennzeichnet, dass** die Resonatoren einendig eingebettete Träger sind.

**5.** MEMS/NEMS-Vorrichtung mit justierbarem Frequenzgang, umfassend Resonatoren mit elektrostatischer Betätigung nach einem der Ansprüche 1 oder 2, **dadurch gekennzeichnet, dass** die Resonatoren zweiendig eingebettete Träger sind.

**6.** MEMS/NEMS-Vorrichtung mit justierbarem Frequenzgang, umfassend Resonatoren mit elektrostatischer Betätigung nach einem der Ansprüche 1 bis 4, **dadurch gekennzeichnet, dass** die Resonatoren Plattenresonatoren sind.

**7.** MEMS/NEMS-Vorrichtung mit justierbarem Frequenzgang, umfassend Resonatoren mit elektrostatischer Betätigung nach Anspruch 6, **dadurch gekennzeichnet, dass** sie Paare von Betätigungselektroden und Paare von Erkennungselektroden umfasst, die mit jedem Plattenresonator gekoppelt sind, die im Lamé-Modus betätigt werden können.

**8.** MEMS/NEMS-Vorrichtung mit justierbarem Frequenzgang, umfassend Resonatoren mit elektrostatischer Betätigung nach einem der Ansprüche 1 bis 7, **dadurch gekennzeichnet, dass** die n Resonatoren eine Steifigkeit und einen Spalt mit der assoziierten Betätigungselektrode haben, die eine direkte Betätigungsspannung für jeden Resonator definiert, approximiert auf den Wert $V_{DC}$ (i) = $V_{IN\,DC}$ - Vi, so dass der Durchschnitt über alle Betätigungsspannungen $M[V_{DC}$ (i)], wobei i von 1 bis n variiert, im Wesentlichen gleich dem Wert n x σ $[V_{DC}$ (i)] ist, wobei σ$[V_{DC}$ (i)] die Standardabweichung der Spannungen ist.

**9.** MEMS/NEMS-Vorrichtung mit justierbarem Frequenzgang nach einem der Ansprüche 1 bis 8, **dadurch gekennzeichnet, dass** die n Resonatoren identische oder quasi- identische geometrische Abmessungen haben.

**10.** RF-Filter mit justierbarem Frequenzgang, umfassend eine MEMS/NEMS-Vorrichtung nach einem der Ansprüche 1 bis 9.

**11.** Frequenzvariationserkennungssensor, umfassend eine MEMS/NEMS-Vorrichtung nach einem der Ansprüche 1 bis 9.

**12.** Masseerkennungssensor, umfassend eine MEMS/NEMS-Vorrichtung nach einem der Ansprüche 1 bis 9.

**13.** Gaserkennungssensor, umfassend eine MEMS/NEMS-Vorrichtung nach einem der Ansprüche 1 bis 9.

**Claims**

**1.** A MEMS/NEMS device with adjustable frequency response comprising a set of resonators with electrostatic actuation, a circuit for electrostatically actuating said resonators, electrical detection means and means for adjusting the frequency response of the set of said resonators,

- said device comprising at least one array of n resonators having a movable part, said n resonators being electrically connected in series between a first biasing potential $V_B$ and a second biasing potential $V_{B2}$, each i-th resonator being biased to a potential Vi between said potential $V_B$ and said potential $V_{B2}$ depending on its position in the series;
- said circuit for electrostatically actuating said resonators comprising, for each resonator, an actuation electrode facing said movable part of said resonator, the set of said actuation electrodes being connected in parallel to a common control potential $V_{IN}$, the actuation voltage of each i-th resonator being equal to $V_{IN}$ - Vi;
- said detection means comprising a detection output common to said n resonators connected to an output potential $V_{out}$;
- said means for adjusting the frequency response varying said common control potential and/or at least one of said first and second biasing potentials.

**2.** The MEMS/NEMS device with adjustable frequency response comprising resonators with electrostatic actuation according to claim 1, **characterised in that** said detection means are capacitive detection means comprising a set of detection electrodes coupled to said n resonators, said detection electrodes being connected to said output potential $V_{out}$.

**3.** The MEMS/NEMS device with adjustable frequency response comprising resonators with electrostatic actuation according to claim 1, **characterised in that** said detection means are piezoresistive means for detecting the resistivity of said set of n resonators connected in series.

**4.** The MEMS/NEMS device with adjustable frequency response comprising resonators with electrostatic actuation according to any one of claims 1 or 2, **characterised in that** said resonators are free-embedded beams.

**5.** The MEMS/NEMS device with adjustable frequency response comprising resonators with electrostatic actuation according to any one of claims 1 or 2, **characterised in that** said resonators are double-embedded beams.

**6.** The MEMS/NEMS device with adjustable frequency response comprising resonators with electrostatic actuation according to any one of claims 1 to 4, **characterised in that** said resonators are plate resonators.

**7.** The MEMS/NEMS device with adjustable frequency response comprising resonators with electrostatic actuation according to claim 6, **characterised in that** it comprises pairs of actuation electrodes and pairs of detection electrodes coupled to each plate resonator that are capable of being actuated in Lamé-mode.

**8.** The MEMS/NEMS device with adjustable frequency response comprising resonators with electrostatic actuation according to any one of claims 1 to 7, **characterised in that** said n resonators have a stiffness and a gap with the associated actuation electrode, defining a DC actuation voltage for each resonator approximated to the value $V_{DC}$ (i) = $V_{IN\,DC}$ - Vi, such that the average over all of the actuation voltages M[$V_{DC}$ (i)], with i varying from 1 to n, is substantially equal to the value n x σ [VD$_C$ (i)], with σ[$V_{DC}$ (i)] being the standard deviation of said voltages.

**9.** The MEMS/NEMS device with adjustable frequency response according to any one of claims 1 to 8, **characterised**

**in that** said n resonators have identical or practically identical geometrical dimensions.

10. An RF filter with adjustable frequency response comprising a MEMS/NEMS device according to any one of claims 1 to 9.

11. A frequency variation detection sensor comprising a MEMS/NEMS device according to any one of claims 1 to 9.

12. A mass detection sensor comprising a MEMS/NEMS device according to any one of claims 1 to 9.

13. A gas detection sensor comprising a MEMS/NEMS device according to any one of claims 1 to 9.

$R_1(f_{R_1})$

$R_2(f_{R_2})$

$R_3(f_{R_3})$

FIG.1

FIG.2

FIG.3

FIG.4

$V_B$ (polarisation)

$E_{A_1}$

$P_1$

$(R+\Delta R)$

Entrée
(actionnement)

$V_{IN\_AC}+V_{IN\_DC}$

$V_1 \quad \left[1+\dfrac{n-1}{n}\right]\dfrac{V_B}{2}$

$P_2 \quad (R+\Delta R)$

$V_2 \quad \left[1+\dfrac{n-2}{n}\right]\dfrac{V_B}{2}$

$E_{A_2}$

$(n-2) \quad P_i \quad (R+\Delta R)$

$E_{A_i}$

$\dfrac{V_B}{2}+V_{OUT\_AC}$

Sortie (détection)

$n \times R$

FIG.5

$V_B$ (polarisation)

PBE$_1$

E$_{A_1}$

E$_{D_1}$

$\dfrac{n-1}{n} V_B$

$V_1$

PBE$_2$

Entrée
(actionnement)

$V_{OUT\_AC}(+V_{IN\_DC})$

Sortie (détection)

$V_{IN\_AC}+V_{IN\_DC}$

E$_{A_2}$

$V_2$

E$_{D_2}$

$\dfrac{n-2}{n} V_B$

FIG.6

$$V_i = \frac{n+1-i}{n+1} V_B$$

FIG.7

FIG.8

FIG.9

FIG.10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2929775
- EP 2197106 A
- FR 2973504
- FR 2917731

**Littérature non-brevet citée dans la description**

- **DE E. SAGE ; O. MARTIN ; C. DUPRÉ ; T. ERNST ; G. BILLIOT ; L. DURAFFOURG ; E. COLINET ; S. HENTZ.** FREQUENCY-ADDRESSED NEMS ARRAYS FOR MASS AND GAS SENSING APPLICATIONS. *proceedings of the IEEE Transducers conference,* 2013
- **J. ARCAMONE ; E. COLINET ; A. NIEL ; E. OLLIER.** Efficient capacitive transduction of high-frequency micromechanicalresonators by intrinsic cancellation of parasitic feedthrough capacitances. *APPLIED PHYSICS LETTERS,* 2010, vol. 97, 043505